# EUROPEAN PATENT APPLICATION

(11) **EP 4 528 364 A1**
(43) Date of publication of application: **26.03.2025**
(21) Application number: 23870481.1
(22) Date of filing: 19.09.2023
(51) Int. Cl.: G02F 1/133, G02F 1/13357, H05K 1/11, H05K 1/18

(54) **CIRCUIT BOARD, BACKLIGHT MODULE, DISPLAY MODULE, AND ELECTRONIC DEVICE**

(30) Priority: 30.09.2022 CN 202211217553
(71) Applicant: Huawei Technologies Co., Ltd., Shenzhen, Guangdong 518129 (CN)
(72) Inventor: FU, Ruhai, Shenzhen, Guangdong 518129 (CN); LI, Xiaoyu, Shenzhen, Guangdong 518129 (CN); ZHAO, Jiahui, Shenzhen, Guangdong 518129 (CN); LIANG, Chaorong, Shenzhen, Guangdong 518129 (CN)
(74) Representative: Körber, Martin Hans
(86) International application number: PCT/CN2023/119701
(87) International publication number: WO 2024/067249

(57) **Abstract**

A circuit board (120), a backlight module (220), a display module, and an electronic device are provided. The circuit board (120) includes at least two sub-boards (10) that are spaced apart, the sub-boards (10) extend in a first direction (y) and are arranged in a second direction (x), the sub-board (10) includes a connection part, connection parts in adjacent sub-boards (10) are connected to each other to form a common connection part (20), and the common connection part (20) extends in the second direction (x). A plurality of functional devices (30) and at least one driver chip (40) are fastened on the sub-board (10). The sub-board (10) is divided into a plurality of partitions (Q), and each partition (Q) includes at least one functional device (30). The circuit board (120) includes a plurality of driving groups (Z), the driving group (Z) includes one driver chip (40) and at least two partitions (Q), and the driver chip (40) is configured to independently drive each partition (Q) in the driving group (Z). The driving groups (Z) include a first driving group (IZ), and a driver chip (40) and partitions (Q) in the first driving group (IZ) are located on a same sub-board (10).

## Description

The present invention claims priority to Chinese Patent Application No. 202211217553.3, filed with the China National Intellectual Property Administration on September 30, 2022 and entitled "CIRCUIT BOARD, BACKLIGHT MODULE, DISPLAY MODULE, AND ELECTRONIC DEVICE", which is incorporated herein by reference in its entirety.

### TECHNICAL FIELD

The present invention relates to the field of circuit board technologies, and in particular, to a circuit board, a backlight module, a display module, and an electronic device.

### BACKGROUND

An LED (light-emitting diode, light-emitting diode) is widely applied to the display field as a light emitting device. In the conventional technology, LEDs are fastened on a circuit board in a manner of being arranged in an array, to form an LED array backlight. The LED array backlight can replace a side-in backlight in a conventional liquid crystal display, and the LED array backlight can implement local dimming. Local dimming is used to adjust brightness of an LED in a local area of the backlight based on display content. In this way, power consumption can be reduced, contrast can be improved, and more perfect HDR (High dynamic range, high dynamic range) effect can be implemented. In the conventional technology, the LED array backlight has technical problems such as a large load difference between partitions, low utilization of the circuit board, and high costs.

### SUMMARY

This application provides a circuit board, a backlight module, a display module, and an electronic device, to resolve technical problems such as a large load difference between partitions on the circuit board, low utilization of the circuit board, and high costs in the conventional technology.

An embodiment of this application provides a circuit board. The circuit board includes at least two sub-boards that are spaced apart, the sub-boards extend in a first direction and are arranged in a second direction, and the first direction and the second direction cross each other. The sub-board includes a connection part, connection parts of adjacent sub-boards are connected to each other to form a common connection part, and the common connection part extends in the second direction.

A plurality of functional devices and at least one driver chip are fastened on the sub-board, the sub-board is divided into a plurality of partitions, and each partition includes at least one functional device.

The circuit board includes a plurality of driving groups. The driving group includes one driver chip and at least two partitions. The driver chip is configured to independently drive each partition in the driving group.

The driving group includes a first driving group, and a driver chip and partitions in the first driving group are located on a same sub-board.

The circuit board provided in this application includes the at least two sub-boards, the adjacent sub-boards are separated by a specific distance, and the connection parts of the adjacent sub-boards are connected to each other to form the common connection part, so that the circuit board is of an integrated structure. The driver chip is disposed on the sub-board, the driver chip can independently control each partition in the driving group in which the driver chip is located, and the driver chip in the first driving group and the partitions controlled by the driver chip are located on the same sub-board. Such disposal can reduce a distance from the partition to the driver chip, and help reduce a load difference between the partitions on the circuit board. In a solution in which the functional device in the partition is an LED, the load difference between the partitions is reduced, so that brightness uniformity of the partitions can be improved. In addition, the driver chip is disposed on the sub-board, and the driver chip is used to control functional devices in at least two partitions, so that a quantity of cables for external connection of the circuit board can be reduced, connection costs can be reduced, and high partitioning (namely, a large quantity of partitions) can be implemented. In addition, connection cabling between the functional device and the driver chip and cabling for external connection of the driver chip are all arranged on the sub-board in a centralized manner, to make full use of space of the sub-board. The spacing distance between the adjacent sub-boards is set, so that a cutting surplus material between the adjacent sub-boards may be used to form sub-boards of another circuit board. That is, an entire raw material of the circuit board can be used to manufacture two circuit boards in this application, so that the raw material can be used to a maximum extent, and material costs can be reduced.

In some implementations, the partitions in the first driving group are arranged in a rows*b columns, a column direction is parallel to the first direction, a row direction is parallel to the second direction, both a and b are positive integers, a≥1, b≥1, and a and b are not 1 at the same time. A plurality of partitions in a same driving group are set in the centralized manner. When a same driver chip is used to control these partitions, a difference between distances from the partitions to the driver chip can be reduced, and a load difference between the partitions in the driving group can be reduced.

In some implementations, the driver chip in the first driving group is located inside an area occupied by the a rows*b columns. Such disposal can reduce the distance between each partition and the driver chip, and reduce the difference between the distances from the partitions in the driving group to the driver chip, and reduce the load difference between the partitions in the driving group.

In some implementations, the driver chip includes an input terminal and an output terminal, and the functional device is coupled to the output terminal. The common connection part includes a plurality of external connection terminals, and an input terminal of each driver chip is coupled to the external connection terminal. The driver chip is connected to an external control circuit via the external connection terminal, to independently control each partition on the sub-board via the driver chip. Such disposal can reduce the quantity of cables for external connection of the circuit board, reduce connection costs, and facilitate high partitioning on each sub-board.

In some implementations, the plurality of functional devices on each sub-board are arranged in a same manner. Such disposal helps improve regularity of arrangement of the functional devices on an entire surface of the circuit board. For example, the functional device is a light emitting device. This helps improve uniformity of light emitting brightness of the entire surface of the circuit board used as a backlight plate.

In some implementations, in the circuit board, two functional devices that are adjacent in the second direction are at an equal spacing. The two functional devices that are adjacent in the second direction are located on a same sub-board, or the two functional devices that are adjacent in the second direction are respectively located on two adjacent sub-boards. Such disposal helps implement uniformity of overall arrangement of the functional devices in the circuit board, and can ensure uniformity of backlight brightness of the circuit board used as a backlight plate in the liquid crystal display field.

In some implementations, the circuit board has a virtual straight line that extends in the second direction, and the virtual straight line intersects each sub-board. A part that is of the virtual straight line and that is located between adjacent sub-boards is a spacing line segment, and each spacing line segment has an equal length. In this way, spacing situations between two adjacent sub-boards are the same. In this way, space for manufacturing sub-boards of another circuit board is reserved in an area between two adjacent sub-boards, so that a raw material can be used to a maximum extent, and material costs can be reduced.

In some implementations, the driving group includes a second driving group, the driver chip in the second driving group is located in the common connection part, and the partitions in the second driving group belong to n sub-boards, where n≥2, and n is an integer. When a quantity of partitions obtained through division on the sub-board is not an integer multiple of a quantity of partitions that can be supported by the driver chip, one driver chip may be set to control a plurality of partitions on different sub-boards. The driver chip is disposed on the common connection part, to ensure that a difference between distances from the driver chip to the partitions that are located on the different sub-boards and that are connected to the driver chip is not too large, and a load difference between the partitions can be reduced. When the circuit board is used as a backlight plate, uniformity of light emitting brightness of an entire surface can be improved.

In some implementations, a shape of the sub-board is any one of a long strip shape, a fold line shape, a sawtooth shape, or a shape of 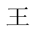 .

In some implementations, the connection part is an end part of the sub-board in the first direction, and each sub-board extends from a same side of the common connection part in a direction away from the common connection part.

In some other implementations, the connection part is an end part of the sub-board in the first direction, and the sub-board includes a first sub-board and a second sub-board. The first sub-board and the second sub-board respectively extend from two sides of the common connection part in a direction away from the common connection part. In the first direction, the first sub-board and the second sub-board are staggered.

In some other implementations, the connection part is an end part of the sub-board in the first direction, and the sub-board includes a first sub-board and a second sub-board. The first sub-board and the second sub-board respectively extend from two sides of the common connection part in a direction away from the common connection part. In the first direction, the first sub-board is aligned with the second sub-board.

In some implementations, b=1 or b=2. A quantity of partition columns obtained through division on a single sub-board is small, so that a spacing between adjacent sub-boards can be reduced, and utilization of the circuit board can be improved while ensuring even distribution of the functional devices on the circuit board.

In this embodiment of this application, the functional device includes at least one of a light emitting device, a photosensitive device, and an ultrasonic device.

Based on a same inventive concept, an embodiment of this application further provides a backlight module. The backlight module includes the circuit board provided in any embodiment of this application.

Based on a same inventive concept, an embodiment of this application further provides a display module. The display module includes a display panel and the backlight module provided in any embodiment of this application.

Based on a same inventive concept, an embodiment of this application further provides an electronic device. The electronic device includes the circuit board provided in any embodiment of this application.

The circuit board, the backlight module, the display module, and the electronic device provided in this application have the following beneficial effect: The circuit board provided in this application includes the at least two sub-boards, the adjacent sub-boards are separated by the specific distance, and the connection parts of the adjacent sub-boards are connected to each other to form the common connection part, so that the circuit board is of an integrated structure. The driver chip is disposed on the sub-board, the driver chip can independently control each partition in the driving group in which the driver chip is located, and the driver chip in the first driving group and the partitions controlled by the driver chip are located on the same sub-board. Such disposal can reduce the distance from the partition to the driver chip, and help reduce the load difference between the partitions on the circuit board. In a solution in which the functional device in the partition is an LED, the load difference between the partitions is reduced, so that brightness uniformity of the partitions can be improved. In addition, the driver chip is disposed on the sub-board, and the driver chip is used to control the functional devices in the at least two partitions, so that the quantity of cables for external connection of the circuit board can be reduced, connection costs can be reduced, and high partitioning can be implemented. In addition, the connection cabling between the functional device and the driver chip and the cabling for external connection of the driver chip are all arranged on the sub-board in the centralized manner, to make full use of the space of the sub-board. The spacing distance between the adjacent sub-boards is set, so that the cutting surplus material between the adjacent sub-boards may be used to form sub-boards of another circuit board. That is, the entire raw material of the circuit board can be used to manufacture two circuit boards in this application, so that the raw material can be used to a maximum extent, and material costs can be reduced.

### BRIEF DESCRIPTION OF DRAWINGS

FIG. 1 is a diagram of a conventional technology;
FIG. 2 is a diagram of another conventional technology;
FIG. 3 is a diagram of another conventional technology;
FIG. 4 is a diagram of a circuit board according to an embodiment of this application;
FIG. 5A is a diagram of another circuit board according to an embodiment of this application;
FIG. 5B is a diagram of another circuit board according to an embodiment of this application;
FIG. 5C is a diagram of another circuit board according to an embodiment of this application;
FIG. 5D is a diagram of another circuit board according to an embodiment of this application;
FIG. 6 is a diagram of another circuit board according to an embodiment of this application;
FIG. 7 is a diagram of another circuit board according to an embodiment of this application;
FIG. 8 is a diagram of another circuit board according to an embodiment of this application;
FIG. 9 is a diagram of another circuit board according to an embodiment of this application;
FIG. 10 is a diagram of another circuit board according to an embodiment of this application;
FIG. 11 is a diagram of another circuit board according to an embodiment of this application;
FIG. 12 is a diagram of another circuit board according to an embodiment of this application;
FIG. 13 is a diagram of another circuit board according to an embodiment of this application;
FIG. 14 is a diagram of another circuit board according to an embodiment of this application;
FIG. 15 is a diagram of another circuit board according to an embodiment of this application;
FIG. 16 is a diagram of another circuit board according to an embodiment of this application;
FIG. 17 is a diagram of another circuit board according to an embodiment of this application;
FIG. 18 is a diagram of a backlight module according to an embodiment of this application; and
FIG. 19 is a diagram of a display module according to an embodiment of this application.

### DESCRIPTION OF EMBODIMENTS

For better understanding of technical solutions of this specification, the following describes embodiments of this application in detail with reference to accompanying drawings.

It should be noted that the described embodiments are merely some but not all of embodiments of this specification. All other embodiments obtained by a person of ordinary skill in the art based on embodiments of this specification without creative efforts shall fall within the protection scope of this specification.

Terms used in embodiments of this application are merely for the purpose of describing specific embodiments, but are not intended to limit this specification. The terms "a", "said" and "the" of singular forms used in embodiments and the appended claims of this application are also intended to include plural forms, unless otherwise specified in the context clearly.

Currently, there are two types of LED backlight driver technologies. One type is an LED driver integrated solution, to be specific, a backlight LED and a driver chip are made on a same circuit board. The other type is an LED driver separated solution, to be specific, a backlight LED is disposed on one circuit board, a driver chip is disposed on another circuit board, and the two circuit boards are connected by using a cable, to implement backlight partition control.

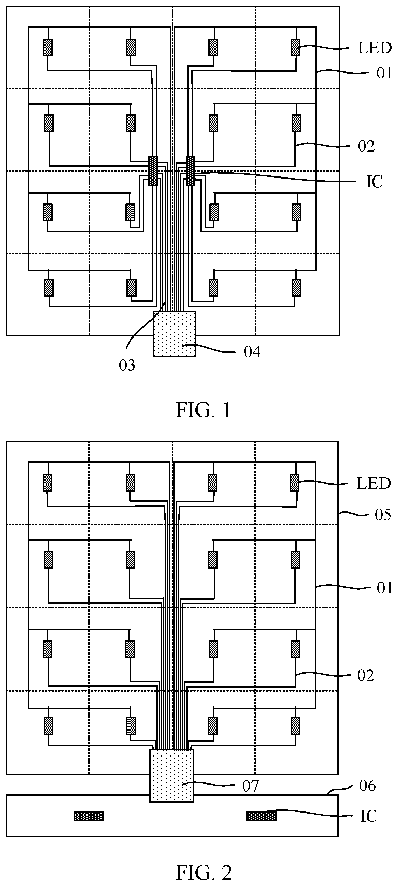

FIG. 1 is a diagram of a conventional technology. FIG. 1 shows an LED driver integrated solution. As shown in FIG. 1, an LED and a driver chip IC are fastened on a same circuit board, the circuit board includes 16 partitions (limited by dashed lines crossing horizontally and vertically), and one LED is disposed in each partition. The 16 partitions are controlled by two driver chip ICs, and each driver chip IC controls eight partitions. A power cable 01 connected to each LED is disposed in the circuit board, and each LED in each partition leads out a signal cable 02 to connect to the driver chip IC. Both the power cable 01 and a communication signal cable 03 that is led out from the driver chip IC are connected to a connector 04, and then connected to an external control circuit via the connector 04. Because at least the power cable 01, the signal cable 02, and the communication signal cable 03 all need to be arranged on the circuit board, cabling on the circuit board is complex. In practice, a two-layer board may need to be used to implement cabling, resulting in high manufacturing costs. However, in this technology, a small quantity of cables are required for external connection of the circuit board, so that connection costs can be reduced.

FIG. 2 is a diagram of another conventional technology. FIG. 2 shows an LED driver separated solution. As shown in FIG. 2, an LED is fastened on a circuit board 05, a driver chip IC is fastened on a circuit board 06, and the circuit board 05 and the circuit board 06 are connected via a connector 07. The circuit board 05 includes 16 partitions, and one LED is disposed in each partition. The 16 partitions are controlled by two driver chip ICs, and each driver chip IC controls eight partitions. A power cable 01 connected to each LED and a signal cable 02 connected to each LED are disposed in the circuit board. Both the signal cable 02 and the power cable 01 are connected to the connector 07, and are connected to a corresponding driver chip IC through cabling (not shown in FIG. 2) on the circuit board 06. The driver chip IC can drive the partitions connected to the driver chip IC independently of each other, to implement partition dimming. The driver chip IC and the LED are separately disposed on different circuit boards. Therefore, cabling on the circuit board 05 in which the LED is located is simple, cabling can be implemented by using a single-layer board, and manufacturing costs can be reduced by using the single-layer circuit board. However, due to LED driver separation, distances between the LEDs and the driver chip ICs in different partitions differ greatly. As a result, loads in different partitions differ greatly, causing a display effect risk and affecting display uniformity. In addition, in this technology, the LED in each partition needs to be connected to the outside by using a signal cable 02, so that the circuit board 05 needs to be connected to the outside by using a large quantity of cables. This increases connection costs. In addition, because signals in the partitions are input in parallel, a cable from each partition needs to be connected to the connector 07. In this case, a cable for external connection is added, so that high partitioning (namely, a large quantity of partitions) cannot be implemented.

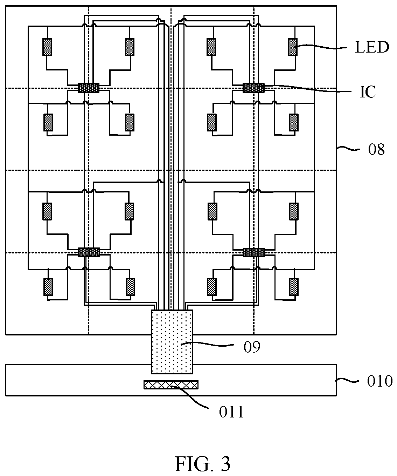

FIG. 3 is a diagram of another conventional technology. As shown in FIG. 3, an LED and a driver chip IC are fastened on a same circuit board 08, the circuit board 08 is connected to a circuit board 010 via a connector 09, and a main controller 011 is fastened on the circuit board 010. The circuit board includes 16 partitions, one LED is disposed in each partition, and one driver chip IC controls LEDs in four partitions. It can be seen from FIG. 3 that cabling on the circuit board 08 is crossed. In this case, a jumper device may be used to ensure that the crossed cabling is insulated from each other. In this way, cabling can be implemented on the circuit board 08 by using a single-layer board, and cabling using the single-layer board can decrease costs. The driver chip IC is fastened on the circuit board 08, and each driver chip IC is then connected to the main controller 011 via the connector 09. The driver chip IC is externally connected to a small quantity of channels. This facilitates implementation of an equal load design of each partition. However, in this technology, an area occupied by the actual cabling on the circuit board 08 is far less than an area of the entire circuit board. This leads to extremely low utilization of the circuit board, and increases costs.

In some conventional technologies, partition dimming can be implemented. However, a load difference between partitions is large, and a display effect risk exists. In addition, a large quantity of cables for external connection increase manufacturing costs. In some other conventional technologies, to implement partition dimming, a circuit board needs to be manufactured by using a two-layer board, and costs are high. In some other conventional technologies, although partition dimming is implemented, space utilization of a circuit board is extremely low. In conclusion, in the conventional technologies, integration of reducing the load difference between the partitions, reducing the cables for external connection, and improving utilization of the circuit board cannot be implemented. To resolve the problems existing in the conventional technologies, this application provides a circuit board, to improve utilization of the circuit board, reduce costs, reduce a load difference between partitions, and reduce cables for external connection of the circuit board.

A functional device is fastened on the circuit board provided in this application. The functional device may be a light emitting device, and the light emitting device may be a light-emitting diode, for example, a mini LED. The mini LED is generally an LED device whose chip size ranges from 50 µm to 200 µm. When the mini LED is fastened on the circuit board, the circuit board may be used as a backlight plate. The backlight plate is used in liquid crystal display to provide a surface light source for a liquid crystal display panel. Partition control is performed on a plurality of LEDs on the backlight plate, to implement partition dimming. The functional device may alternatively be a photosensitive device or an ultrasonic device.

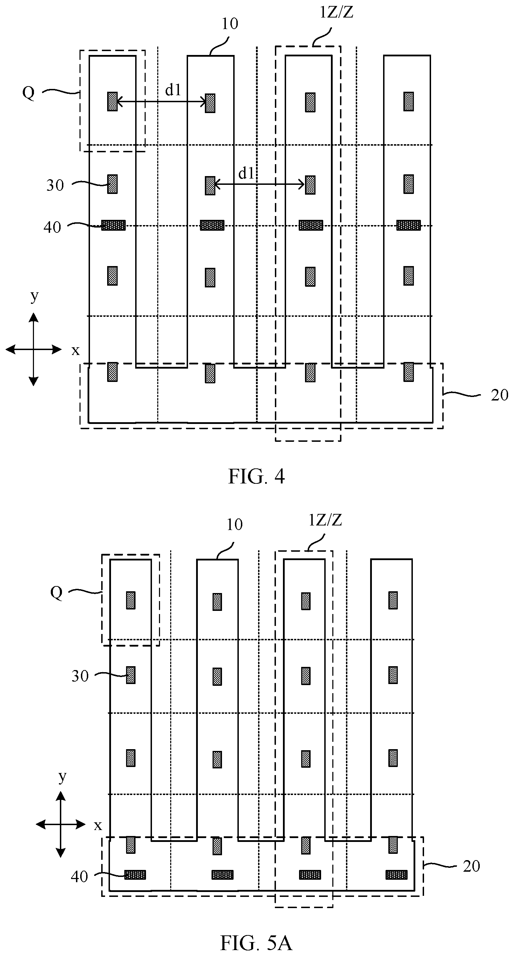

FIG. 4 is a diagram of a circuit board according to an embodiment of this application. As shown in FIG. 4, the circuit board includes at least two sub-boards 10 that are spaced apart, and the sub-boards 10 have a same shape. The sub-boards 10 extend in a first direction y and are arranged in a second direction x, and the first direction y and the second direction x cross each other. Adjacent sub-boards 10 in the circuit board are spaced by a specific distance, and the adjacent sub-boards 10 are connected to each other at a local position, so that the circuit board is actually of an integrated structure. The sub-board 10 includes a connection part (not marked in FIG. 4), the connection part is a part of the sub-board 10, connection parts in the adjacent sub-boards 10 are connected to each other to form a common connection part 20, and the common connection part 20 extends in the second direction x. Disposal of the common connection part 20 implements interconnection between the sub-boards 10 at the local position. A shape of the circuit board shown in FIG. 4 is approximately a comb shape. In this embodiment of this application, a quantity of sub-boards 10 included in the circuit board is not limited. FIG. 4 is merely an example in which four sub-boards 10 are included.

As shown in FIG. 4, a plurality of functional devices 30 and at least one driver chip 40 are fastened on the sub-board 10. The sub-board 10 is divided into a plurality of partitions Q, and each partition Q includes at least one functional device 30. In FIG. 4, a unit area defined by dashed lines crossing horizontally and vertically is the partition Q on the sub-board 10, and one functional device 30 is disposed in each partition Q. When the partition Q includes two or more functional devices 30, the functional devices 30 in the partition Q are connected in parallel or in series. The partition Q is equivalent to dividing an entity area of the sub-board 10. A quantity of functional devices 30 in each partition Q obtained through dividing on the same sub-board 10 may be the same or different.

The circuit board includes a plurality of driving groups Z. The driving group Z includes one driver chip 40 and at least two partitions Q. The driver chip 40 is configured to independently drive each partition Q in the driving group Z. To be specific, the partitions Q in the driving group Z may be controlled independently of each other and do not interfere with each other. In other words, one driver chip 40 and two or more partitions Q controlled by the driver chip 40 form one driving group Z. The driving group Z is understood as dividing the circuit board in driving logic.

Each sub-board 10 includes at least one driving group Z, the driving group includes a first driving group 1Z, and a driver chip 40 and partitions Q in the first driving group 1Z are located on the same sub-board 10.

The circuit board provided in this application includes at least two sub-boards 10, the adjacent sub-boards 10 are spaced by the specific distance, and connection parts of the adjacent sub-boards 10 are connected to each other to form the common connection part 20, so that the circuit board is of an integrated structure. The driver chip 40 is disposed on the sub-board 10, the driver chip 40 can independently control each partition Q in the driving group Z in which the driver chip 40 is located, and the driver chip 40 in the first driving group 1Z and the partitions Q controlled by the driver chip 40 are located on the same sub-board 10. Such disposal can reduce a distance from the partition Q to the driver chip 40, and help reduce a load difference between the partitions Q on the circuit board. In a solution in which the functional device 30 in the partition Q is an LED, the load difference between the partitions Q is reduced, so that brightness uniformity of the partitions Q can be improved. In addition, the driver chip 40 is disposed on the sub-board 10, and the driver chip 40 is used to control the functional devices 30 in the at least two partitions Q, so that a quantity of cables for external connection of the circuit board can be reduced, connection costs can be reduced, and high partitioning (namely, a large quantity of partitions) can be implemented. In addition, connection cabling between the functional device 30 and the driver chip 40 and cabling for external connection of the driver chip 40 are all arranged on the sub-board 10 in a centralized manner, to make full use of space of the sub-board 10. The spacing distance between the adjacent sub-boards 10 is set, so that a cutting surplus material between the adjacent sub-boards 10 may be used to form sub-boards of another circuit board. That is, an entire raw material of the circuit board can be used to manufacture two circuit boards in this application, so that the raw material can be used to a maximum extent, and material costs can be reduced.

In FIG. 4, an example in which one sub-board 10 includes one first driving group 1Z is used for only illustration. In this case, one driver chip 40 is disposed on one sub-board 10. A quantity of driver chips 40 disposed on the sub-board 10 is not limited in this embodiment of this application. Drive performance (namely, a quantity of partitions Q that can be supported by the driver chip 40) of the driver chip 40 may be combined, and a quantity of driving groups Z included in the sub-board 10 is set for a quantity and positions of driver chips 40 on the sub-board 10.

In some implementations, as shown in FIG. 4, the partitions Q in the first driving group 1Z on the sub-board 10 are arranged in a rows*b columns, and the driver chip 40 is located inside an area occupied by the a rows*b columns. A column direction is parallel to the first direction y, a row direction is parallel to the second direction x, both a and b are positive integers, a≥1, b≥1, and a and b are not 1 at the same time. The partitions Q in the first driving group 1Z are set to be arranged in an array, that is, a plurality of partitions Q in a same driving group are set in the centralized manner. When a same driver chip 40 is used to control these partitions Q, a difference between distances from the partitions Q to the driver chip 40 can be reduced, and a load difference between the partitions Q in the driving group Z can be reduced. Further, the driver chip 40 in the first driving group 1Z is disposed inside an area occupied by the plurality of partitions Q driven by the driver chip 40, so that distances from the partitions Q to the driver chip 40 can be reduced. In addition, a difference between the distances from the partitions Q to the driver chip 40 in the driving group Z can be reduced, and the load difference between the partitions Q in the driving group Z can be reduced.

In some implementations, the driver chip 40 is located in a middle part of the area occupied by the a rows*b columns. That "the driver chip 40 is located in a middle part of the area occupied by the a rows*b columns" is understood as that the driver chip 40 is disposed at a position close to a center of the area occupied by the partitions Q arranged in the array. Such disposal can further reduce the difference between the distances from the partitions Q to the driver chip 40, so that the distances from the partitions Q to the driver chip 40 are basically the same.

As shown in FIG. 4, one sub-board 10 includes one first driving group 1Z, and the first driving group 1Z on the sub-board 10 includes four partitions Q in four rows and one column, that is, a=4 and b=1. The driver chip 40 in the first driving group 1Z on the sub-board 10 is located between a partition Q in a third row and a partition Q in a fourth row, that is, the driver chip 40 is disposed in a middle part of the four rows*one column.

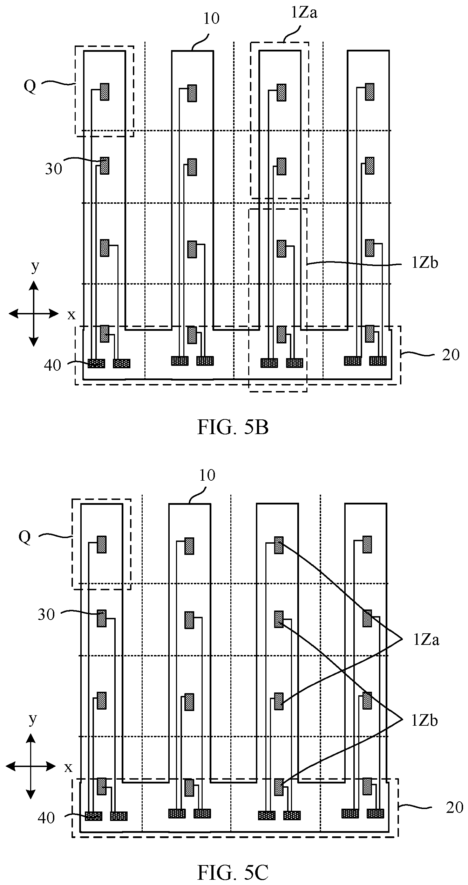

In some other implementations, FIG. 5A is a diagram of another circuit board according to an embodiment of this application. As shown in FIG. 5A, the sub-board 10 includes a first driving group 1Z, and the first driving group 1Z includes one driver chip 40 and four partitions Q, and the driver chip 40 is located at one end of the four partitions Q controlled by the driver chip 40, or it may be considered that the driver chip 40 is located inside an area occupied by a plurality of partitions Q controlled by the driver chip 40. In some other implementations, FIG. 5B is a diagram of another circuit board according to an embodiment of this application. As shown in FIG. 5B, an example in which the sub-board 10 includes two driving groups, namely, a first driving group 1Za and a first driving group 1Zb, is used for illustration. The first driving group 1Za and the first driving group 1Zb each include one driver chip 40 and two partitions Q. That the functional device 30 is connected to the driver chip 40 indicates that the driver chip 40 can perform driving control on the functional device 30. The driver chip 40 in the first driving group 1Za, the driver chip 40 in the first driving group 1Zb, and the partitions Q controlled by the driver chips 40 are located on the same sub-board 10. For the first driving group 1Za, the driver chip 40 in the driving group is located outside an area occupied by the two partitions Q controlled by the driver chip 40. For the first driving group 1Zb, the driver chip 40 in the driving group is located inside an area occupied by the two partitions Q controlled by the driver chip 40. In the foregoing embodiment, it is shown that partitions Q belonging to one driving group Z on the sub-board 10 are arranged in an array. In some other implementations, when one sub-board 10 includes two or more driving groups Z, partitions Q belonging to one driving group Z may alternatively be disposed in a distributed manner.

In some implementations, FIG. 5C is a diagram of another circuit board according to an embodiment of this application. As shown in FIG. 5C, the sub-board 10 includes two driving groups, namely, a first driving group 1Za and a first driving group 1Zb, a driver chip 40 in the first driving group 1Za, a driver chip 40 in the first driving group 1Zb, partitions Q controlled by the driver chips 40 are located on the same sub-board 10. Partitions Q belonging to the first driving group 1Za and partitions Q belonging to the first driving group 1Zb are alternately arranged in the first direction y. For the first driving group 1Za, the driver chip 40 in the driving group is located outside areas occupied by two partitions Q controlled by the driver chip 40. For the first driving group 1Zb, it may be considered that the driver chip 40 in the driving group is located inside an area occupied by one partition Q controlled by the driver chip 40. When driver chips 40 in some driving groups on the sub-board 10 are not disposed inside areas occupied by partitions Q controlled by the driver chips 40, a plurality of partitions Q belonging to different driving groups on the sub-board may be alternately arranged. In this way, a load difference between the partitions Q belonging to the different driving groups is reduced.

In some implementations, the driver chip 40 includes an input terminal and an output terminal, a terminal that is on the driver chip 40 and that is configured to connect to an external control circuit is the input terminal, and a terminal that is on the driver chip 40 and that is configured to output a signal to the functional device 30 is the output terminal. The functional device 30 is coupled to the output terminal of the driver chip 40. The common connection part 20 of the circuit board includes a plurality of external connection terminals, and an input terminal of each driver chip 40 is coupled to the external connection terminal. The driver chip 40 is disposed on the sub-board 10, and the functional device 30 on the sub-board 10 is controlled via the driver chip 40. A signal cable is led out from the driver chip 40 to the external connection terminal, and then connected to the external control circuit. The external control circuit provides a data signal to the driver chip 40, to separately control each partition Q on the sub-board 10 via the driver chip 40. Such disposal can reduce a quantity of cables for external connection of the circuit board, reduce connection costs, and facilitate high partitioning on each sub-board 10.

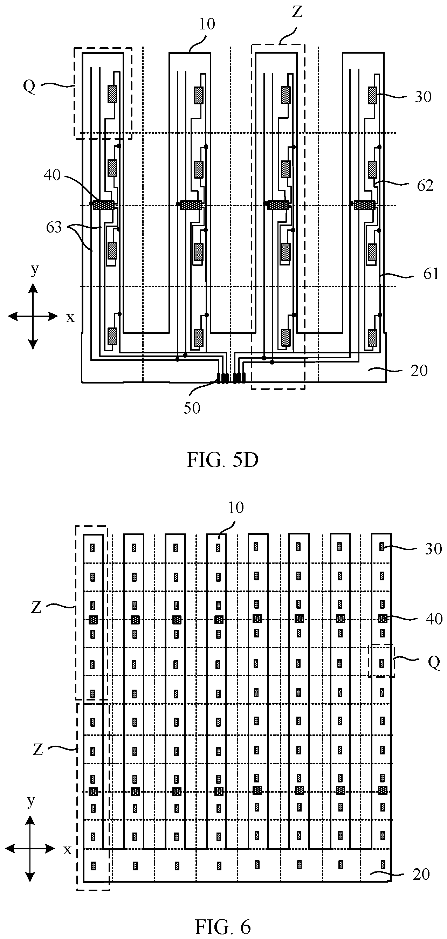

FIG. 5D is a diagram of another circuit board according to an embodiment of this application. FIG. 5D shows an optional cabling manner on the circuit board. For example, the functional device 30 is an LED. The LED includes an anode and a cathode, and one of the anode and the cathode may be used as a common electrode. As shown in FIG. 5D, a common electrode cable 61 and an electrode signal cable 62 are arranged on the sub-board 10, one end of the common electrode cable 61 is connected to an external connection terminal 50 on the common connection part 20, and one electrode of the functional device 30 is connected to the common electrode cable 61. Two ends of the electrode signal cable 62 are respectively connected to the other electrode of the functional device 30 and the output terminal of the driver chip 40. Optionally, the anode of the functional device 30 is connected to the common electrode cable 61, and the cathode of the functional device 30 is connected to the electrode signal cable 62. FIG. 5D further shows two external signal cables 63. The input terminal of the driver chip 40 is connected to the external signal cable 63, and one end of the external signal cable 63 is connected to the external connection terminal 50. The external signal cable 63 includes at least a power cable, a ground cable, and a communication signal cable.

As shown in FIG. 5D, one electrode of the functional device 30 is connected to the driver chip 40, and the other electrode is connected to the external connection terminal 50. In another implementation, the two electrodes of the functional device 30 are connected to the driver chip 40. This is not shown in the accompanying drawings herein.

In some implementations, the functional devices 30 on each sub-board 10 are arranged in a same manner. FIG. 6 is a diagram of another circuit board according to an embodiment of this application. As shown in FIG. 6, the plurality of functional devices 30 on each sub-board 10 are arranged in one column. Arrangement manners of the functional devices 30 on the sub-boards 10 are set to be the same. This helps improve regularity of arrangement of the functional devices 30 on an entire surface of the circuit board. For example, the functional device 30 is a light emitting device. This helps improve uniformity of light emitting of the entire surface of the circuit board used as a backlight plate.

As shown in FIG. 6, a unit area defined by dashed lines crossing horizontally and vertically is a partition Q. As shown in the embodiment in FIG. 6, each sub-board 10 includes two driving groups Z, each driving group Z includes one driver chip 40 and six partitions Q, one functional device 30 is disposed in each partition Q, and the driver chip 40 is located inside an area occupied by the six partitions Q that are arranged in the first direction y and that are connected to the driver chip 40.

FIG. 6 shows only positions of the driver chip 40 and the functional device 30 on the sub-board 10, and does not show cabling on the circuit board. For a cabling manner on the circuit board, refer to the foregoing embodiment in FIG. 5D for setting.

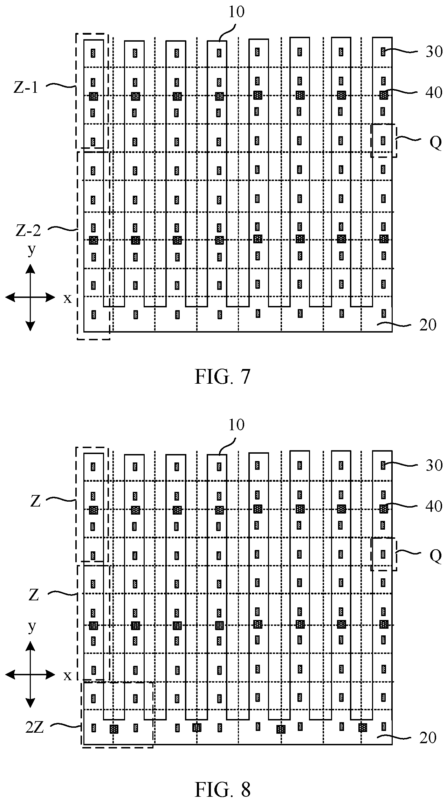

As shown in the embodiment in FIG. 6, each driving group Z includes a same quantity of partitions Q. In some implementations, FIG. 7 is a diagram of another circuit board according to an embodiment of this application. In FIG. 7, a unit area defined by dashed lines crossing horizontally and vertically is a partition Q. As shown in FIG. 7, the sub-board 10 includes a first sub-driving group Z-1 and a second sub-driving group Z-2, the first sub-driving group Z-1 includes one driver chip 40 and four partitions Q, and the second sub-driving group Z-2 includes one driver chip 40 and six partitions Q. It may be set, based on a specific design requirement, that quantities of partitions Q included in the driving groups Z in the circuit board are not completely the same.

As shown in FIG. 7, the first sub-driving group Z-1 and the second sub-driving group Z-2 that include different quantities of partitions Q are located on the same sub-board 10. In some other implementations, the first sub-driving group Z-1 and the second sub-driving group Z-2 that include different quantities of partitions Q are located on different sub-boards 10. This is not shown in the accompanying drawings herein.

In some implementations, a plurality of partitions Q in some driving groups Z are located on different sub-boards 10. FIG. 8 is a diagram of another circuit board according to an embodiment of this application. As shown in FIG. 8, the driving group Z includes a second driving group 2Z, and a driver chip 40 in the second driving group 2Z is located on the common connection part 20, and partitions Q in the second driving group 2Z belong to n sub-boards 10, n≥2, and n is an integer. In FIG. 8, n=2 is used for description. In practice, area division is performed on the sub-board 10 based on a precision requirement of partition control, then the driving group Z is defined with reference to a quantity of partitions that can be supported by the driver chip 40, and a disposition position of the driver chip 40 on the sub-board 10 is determined. When a quantity of partitions Q obtained through division on the sub-board 10 is not an integer multiple of the quantity of partitions that can be supported by the driver chip 40, one driver chip 40 may be set to control a plurality of partitions Q on different sub-boards 10. The driver chip 40 is disposed on the common connection part 20, to ensure that a difference between distances from the driver chip 40 to the partitions Q that are located on the different sub-boards 10 and that are connected to the driver chip 40 is not too large, and a load difference between the partitions Q can be reduced. When the circuit board is used as a backlight plate, uniformity of light emitting of an entire surface can be improved.

In some implementations, the partitions Q in the second driving group 2Z belong to n sequentially adjacent sub-boards 10. In this way, the distance from the partition Q to the driver chip 40 can be shortened, the load of the partition Q can be reduced, and cross cabling on the common connection part 20 can be avoided. In this way, a cabling manner can be simplified, and cabling space can be saved.

In some other implementations, n=3 or n=4. This is not shown in the accompanying drawings herein.

In some implementations, the circuit board includes a first driving group 1Z and a second driving group 2Z, and quantities of partitions Q included in the first driving group 1Z and the second driving group 2Z may be the same or may be different.

In some implementations, the circuit board includes two or more first driving groups 1Z, and quantities of partitions Q included in different first driving groups 1Z may be the same or may be different.

In some implementations, as shown in FIG. 4, the common connection part 20 is located at an end part of the circuit board in the first direction y. The connection part is equivalent to an end part of the sub-board 10 in the first direction y, and each sub-board 10 extends from a same side of the common connection part 20 in a direction away from the common connection part 20.

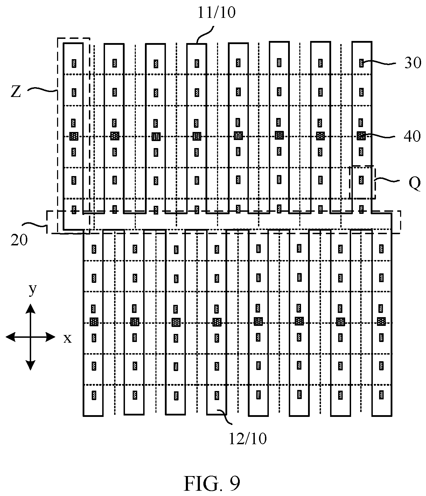

In some other implementations, FIG. 9 is a diagram of another circuit board according to an embodiment of this application. As shown in FIG. 9, the connection part is an end part of the sub-board 10 in the first direction y, and the sub-board 10 includes a first sub-board 11 and a second sub-board 12. The first sub-board 11 and the second sub-board 12 respectively extend from two sides of the common connection part 20 in a direction away from the common connection part 20. In the first direction y, the first sub-board 11 and the second sub-board 12 are staggered. From a perspective of an overall structure of the circuit board, the common connection part 20 in this implementation is located in a middle part of the circuit board. As shown in FIG. 9, the first sub-board 11 and the second sub-board 12 each include a driving group Z, and each driving group Z includes a driver chip 40 and six partitions Q. Lengths of the first sub-board 11 and the second sub-board 12 in the first direction y are basically the same.

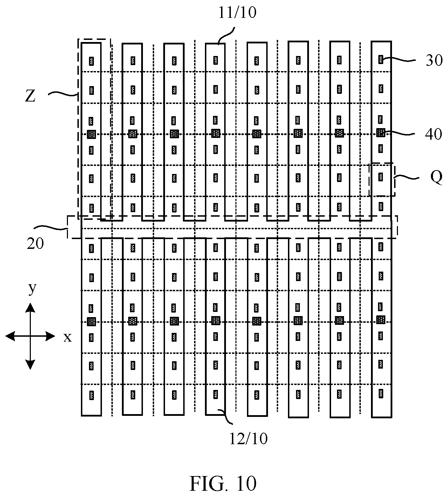

In some other implementations, FIG. 10 is a diagram of another circuit board according to an embodiment of this application. As shown in FIG. 10, the connection part is an end part of the sub-board 10 in the first direction y, and the sub-board 10 includes a first sub-board 11 and a second sub-board 12. The first sub-board 11 and the second sub-board 12 respectively extend from two sides of the common connection part 20 in a direction away from the common connection part 20. In the first direction y, the first sub-board 11 is aligned with the second sub-board 12. From a perspective of an overall structure of the circuit board, the common connection part 20 is located in a middle part of the circuit board. In other words, the connection part is located between two end parts of the sub-board 10 in the first direction y, and the sub-boards 10 separately extend outward from two sides of the common connection part 20. As shown in FIG. 10, the first sub-board 11 and the second sub-board 12 each include a driving group Z, and each driving group Z includes a driver chip 40 and six partitions Q. Lengths of the first sub-board 11 and the second sub-board 12 in the first direction y are basically the same.

Both the embodiments in FIG. 9 and FIG. 10 show that the lengths of the first sub-board 11 and the second sub-board 12 in the first direction y are basically the same. In some other implementations, the first sub-board 11 and the second sub-board 12 respectively extend from two sides of the common connection part 20 in a direction away from the common connection part 20, and lengths of the first sub-board 11 and the second sub-board 12 in the first direction y are different. In this implementation, from a perspective of an overall structure of the circuit board, the common connection part 20 deviates from a middle position of the circuit board, and a quantity of driving groups Z included in the first sub-board 11, a quantity of driving groups Z included in the second sub-board 12, and a quantity of partitions Q included in the driving group Z may be different. This is not shown in the accompanying drawings herein.

In the foregoing embodiment, the shape of the sub-board 10 is illustrated by a long strip shape, and the shape of the sub-board 10 may alternatively be a fold line shape, a sawtooth shape, a shape of 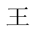 , or a fishbone shape. A specific shape of the sub-board 10 may be flexibly set based on a more design requirement.

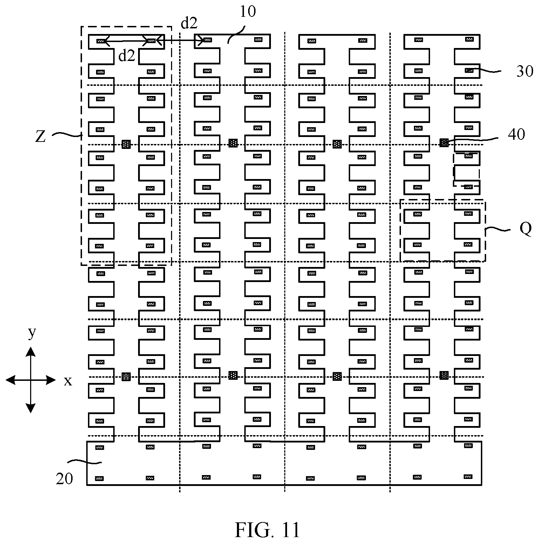

In some implementations, FIG. 11 is a diagram of another circuit board according to an embodiment of this application. As shown in FIG. 11, the shape of the sub-board 10 is a shape of 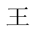 , or may be referred to as a fishbone shape. A unit area defined by dashed lines crossing horizontally and vertically is a partition Q on the sub-board 10. The plurality of partitions Q on the sub-board 10 are arranged in the first direction y, that is, arranged in a manner of a plurality of rows and one column. In this case, in a partition array of a rows*b columns, b=1. Each partition Q includes four functional devices 30, and in the driving group Z, the driver chip 40 controls four partitions Q connected to the driver chip 40. The four functional devices 30 in the partition Q are connected in parallel or in series.

In an embodiment, the circuit board is a backlight plate, and the functional device 30 is a light emitting device, for example, a mini LED. Four LEDs are disposed in one partition Q. This helps reduce a spacing distance between adjacent LEDs in the second direction x. In this case, a light mixture distance between adjacent LEDs can be reduced. This helps reduce a thickness of a backlight module in application.

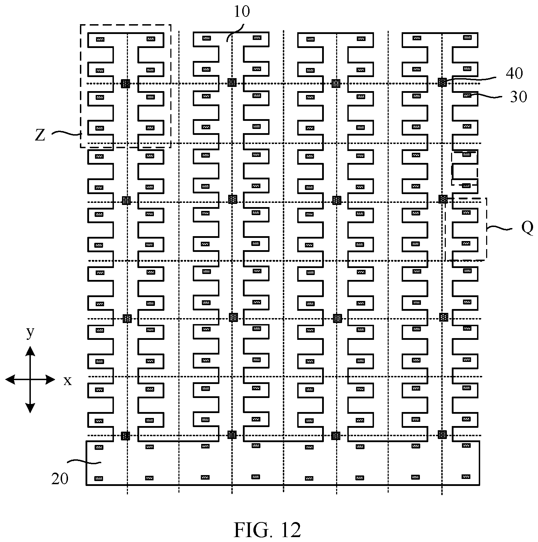

In some other implementations, FIG. 12 is a diagram of another circuit board according to an embodiment of this application. An arrangement manner of the functional devices 30 on the sub-board 10 in the embodiment in FIG. 12 is the same as that in the embodiment in FIG. 11, and a difference lies in a division manner of the partitions Q on the sub-board 10. As shown in FIG. 12, each partition Q includes two functional devices 30, and the partitions Q on the sub-board 10 are arranged in a plurality of rows and two columns, that is, in a partition array of a rows*b columns, b=2. The driver chip 40 in the driving group Z controls four partitions Q connected to the driver chip 40, and the driver chip 40 is located inside an area occupied by the four partitions Q controlled by the driver chip 40.

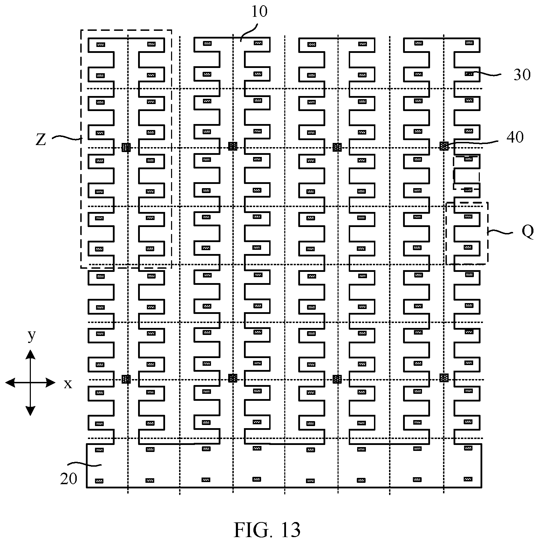

In some other implementations, FIG. 13 is a diagram of another circuit board according to an embodiment of this application. The shape of the sub-board 10 and a division manner of the partitions Q on the sub-board 10 in the embodiment of FIG. 13 are the same as those in the embodiment of FIG. 12. As shown in FIG. 13, each partition Q includes two functional devices 30, and the driver chip 40 in the driving group Z controls eight partitions Q connected to the driver chip 40.

With reference to the embodiments in FIG. 11 to FIG. 13, when the arrangement manner of the functional devices 30 on the sub-board 10 is determined, the driving group Z may be designed differently with reference to the division manner of the partitions Q on the sub-board 10 of the circuit board and a quantity of partitions Q that can be supported by the driver chip 40.

As shown in the embodiments in FIG. 12 and FIG. 13, two partition columns are obtained through division on one sub-board 10, that is, b=2. In some other implementations, based on different shapes of the sub-board 10, in the partition array of the a rows*b columns, b=3 or 4.

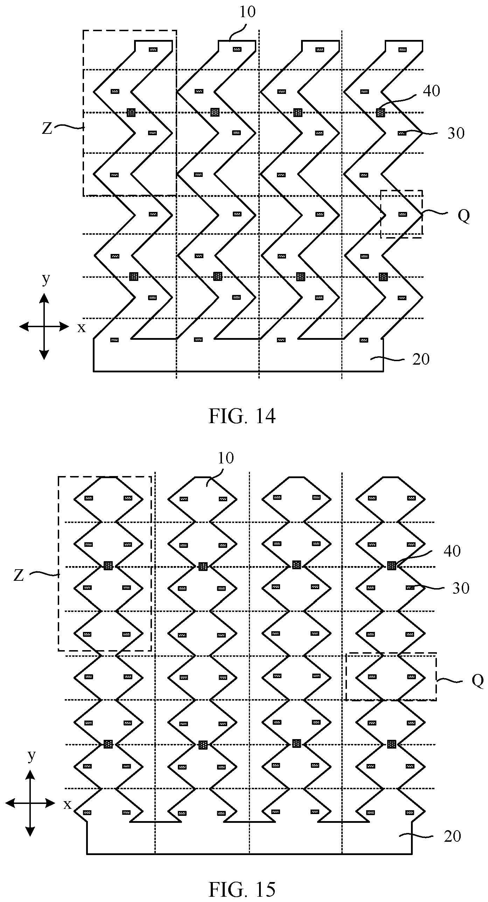

In some other implementations, FIG. 14 is a diagram of another circuit board according to an embodiment of this application. As shown in FIG. 14, the shape of the sub-board 10 is a fold line shape. A unit area defined by dashed lines crossing horizontally and vertically is a partition Q on the sub-board 10. A plurality of partitions Q on the sub-board 10 are arranged in the first direction y, and in a partition array of a rows*b columns, b=1. One functional device 30 is disposed in each partition Q. The driving group Z on the sub-board 10 includes one driver chip 40 and four partitions Q.

In some other implementations, FIG. 15 is a diagram of another circuit board according to an embodiment of this application. As shown in FIG. 15, the shape of the sub-board 10 is a sawtooth shape, and a plurality of partitions Q on the sub-board 10 are arranged in the first direction y. In this case, in a partition array of a rows*b columns, b=1. Two functional devices 30 are disposed in each partition Q. The driving group Z on the sub-board 10 includes one driver chip 40 and four partitions Q.

In the embodiments in FIG. 14 and FIG. 15, an example in which one driving group Z includes four partitions Q is used for illustration. A quantity of partitions Q included in the driving group Z in the circuit board that has a same shape as that in FIG. 14 or FIG. 15 is not limited in this application. The quantity of partitions Q included in the driving group Z may be an odd number or an even number.

FIG. 11, FIG. 14, and FIG. 15 show the three shapes of the sub-boards 10, and the shapes of the sub-boards 10 in the same circuit board are the same. A spacing between adjacent sub-boards 10 is appropriately designed, so that a cutting surplus material between the adjacent sub-boards 10 can be used to form sub-boards of another circuit board. In this way, a raw material can be used to a maximum extent, and material costs can be reduced.

The shapes of the sub-board 10 in FIG. 11, FIG. 14, and FIG. 15 may also be applied in combination with FIG. 9 or FIG. 10. For example, the sub-board 10 in a shape of 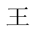 shown in FIG. 11 is applied in combination with FIG. 9. Both the long strip-shaped first sub-board 11 and second sub-board 12 in FIG. 9 may be replaced with sub-boards in a shape of 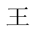 . This is not shown in the accompanying drawings herein.

In some implementations, two functional devices 30 that are adjacent in the second direction x in the circuit board are at an equal spacing. This helps implement uniformity of overall arrangement of the functional devices 30 in the circuit board, and can ensure uniformity of backlight brightness of the circuit board used as a backlight plate in the liquid crystal display field. As shown in FIG. 4, two functional devices 30 that are adjacent in the second direction x are respectively located on two adjacent sub-boards 10, and the spacing between the two functional devices 30 that are adjacent in the second direction x is d1. As shown in FIG. 11, a spacing between two functional devices 30 that are adjacent in the second direction x and that are located on the same sub-board 10 is d2, and a spacing between two functional devices 30 that are adjacent to each other in the second direction x and that are respectively located on two adjacent sub-boards 10 is d2. In other words, any two functional devices 30 that are adjacent in the second direction x are at an equal spacing.

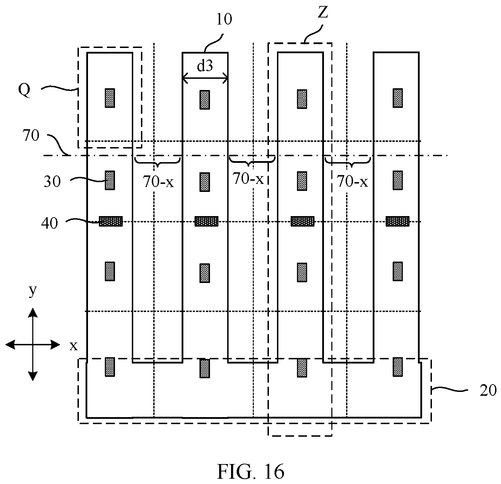

In some implementations, for example, the sub-board 10 is in a long strip shape. FIG. 16 is a diagram of another circuit board according to an embodiment of this application. As shown in FIG. 16, the circuit board has a virtual straight line 70 extending in the second direction x, and the virtual straight line 70 intersects each sub-board 10. A part that is in the virtual straight line 70 and that is located between adjacent sub-boards 10 is a spacing line segment 70-x, and each spacing line segment 70-x has an equal length. In an embodiment in which the sub-board 10 is in a long strip shape, the length of the spacing line segment 70-x is equal to a spacing distance between two adjacent sub-boards 10. A width of the sub-board 10 in the second direction x is d3. Optionally, the length of the spacing line segment 70-x is greater than d3. When cutting is performed along an edge of the sub-board 10 to form the circuit board, a part of material may be lost in a cutting process, and the length of the spacing line segment 70-x is set to be greater than d3, so that a cutting surplus material between the two adjacent sub-boards 10 can be used to form sub-boards of another circuit board. In this way, a raw material can be used to a maximum extent, and material costs can be reduced.

In the embodiment of FIG. 16, only an example in which the sub-board 10 is in a long strip shape is used for description. For the sub-board 10 in a shape of 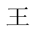 in the embodiment of FIG. 11, space between the adjacent sub-boards 10 is not in a regular shape, and a size of the spacing between the adjacent sub-boards 10 cannot be accurately defined.

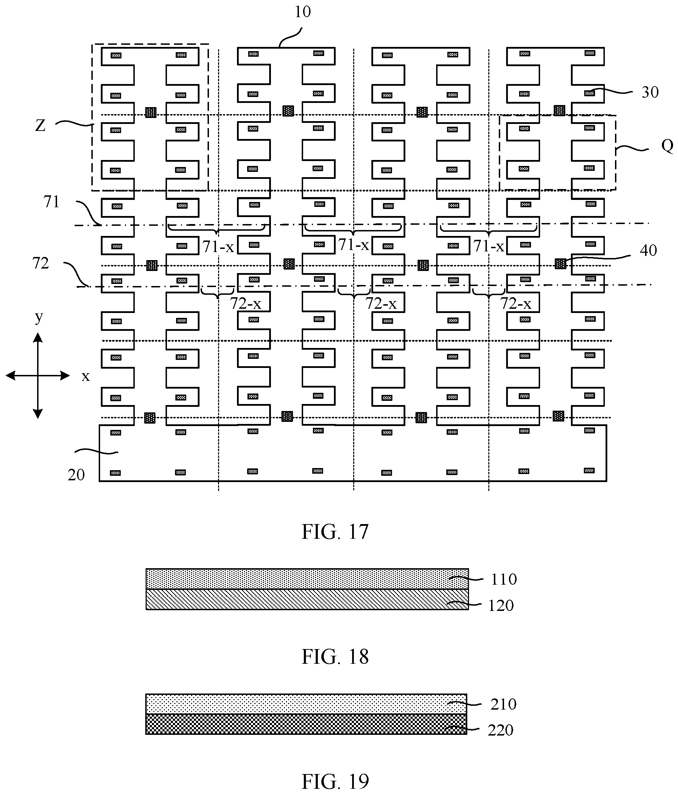

FIG. 17 is a diagram of another circuit board according to an embodiment of this application. As shown in FIG. 17, the circuit board has a first virtual straight line 71 and a second virtual straight line 72 that extend in the second direction x, and the first virtual straight line 71 and the second virtual straight line 72 intersect with each sub-board 10. A part that is of the first virtual straight line 71 and that is located between adjacent sub-boards 10 is a first spacing line segment 71-x, and each first spacing line segment 71-x has an equal length. A part that is of the second virtual straight line 72 and that is located between adjacent sub-boards 10 is a second spacing line segment 72-x, and each second spacing line segment 72-x has an equal length. The first virtual straight line 71 and the second virtual straight line 72 separately intersect with different parts of the sub-board 10, and lengths of spacing line segments are set to be equal, which indicates that spacing situations between two adjacent sub-boards 10 are the same. In this way, space for manufacturing sub-boards of another circuit board is reserved in an area between two adjacent sub-boards 10, so that a raw material can be used to a maximum extent, and material costs can be reduced.

An embodiment of this application provides a backlight module. FIG. 18 is a diagram of the backlight module according to an embodiment of this application. As shown in FIG. 18, the backlight module includes an optical membrane assembly 110 and at least one circuit board 120, and the optical membrane assembly 110 and the circuit board 120 are stacked. The circuit board 120 is the circuit board provided in any embodiment of this application, and a functional device 30 on the circuit board 120 is a light emitting device, for example, a mini LED device. The circuit board 120 is used as a light source, namely, a backlight plate, of the backlight module. A size of the circuit board 120 needs to match a designed size of the backlight module. The light source of the backlight module may include one circuit board 120, or two or more circuit boards 120 may be assembled as a light source. Quantities of partitions on different circuit boards 120 may be different. The optical membrane assembly 110 may include a brightness enhancement film, a diffuser, and the like.

An embodiment of this application further provides a display module. FIG. 19 is a diagram of a display module according to an embodiment of this application. As shown in FIG. 19, the display module includes a display panel 210 and a backlight module 220 that are disposed opposite to each other, the display panel 210 is a liquid crystal display panel, and the backlight module 220 is a backlight module provided in an embodiment of this application.

An embodiment of this application further provides an electronic device. The electronic device includes the circuit board provided in any embodiment of this application.

In an embodiment, the functional device 30 on the circuit board is a light emitting device, the circuit board is a light source in the backlight module, and the electronic device is a display device. The electronic device may be, for example, a mobile phone, a computer, a television, a vehicle-mounted display device, or an intelligent wearable device.

In the descriptions of this specification, a description of a reference term such as "an embodiment", "some embodiments", "an example", "a specific example", or "some examples" means that a specific feature, structure, material, or characteristic that is described with reference to the embodiment or the example is included in at least one embodiment or example of this application. In the specification, the foregoing example expressions of the terms are not necessarily with respect to a same embodiment or example. In addition, the described specific features, structures, materials, or characteristics may be combined in an appropriate manner in any one or more of the embodiments or examples. In addition, a person skilled in the art may integrate or combine different embodiments or examples and characteristics of different embodiments or examples described in the specification, as long as they do not conflict each other.

In addition, the terms "first" and "second" are merely intended for a purpose of description, and shall not be understood as an indication or implication of relative importance or implicit indication of the number of indicated technical features. Therefore, a feature limited by "first" or "second" may explicitly or implicitly include at least one of such features. In the descriptions of this application, "a plurality of" means at least two, for example, two or three, unless otherwise clearly limited.

Any process or method in the flowcharts or described herein in another manner may be understood as indicating a module, a segment, or a part including code of one or more executable instructions for implementing a particular logical function or process step. In addition, the scope of preferred embodiments of this application includes other implementations that do not follow the order shown or discussed, including performing, according to involved functions, the functions basically simultaneously or in a reverse order, which should be understood by technical personnel in the technical field to which embodiments of this application belong.

## Claims

1. A circuit board, wherein the circuit board comprises at least two sub-boards that are spaced apart, the sub-boards extend in a first direction and are arranged in a second direction, the first direction and the second direction cross each other, the sub-board comprises a connection part, the connection part of adjacent sub-boards are connected to each other to form a common connection part, and the common connection part extends in the second direction;
a plurality of functional devices and at least one driver chip are fastened on the sub-board, the sub-board is divided into a plurality of partitions, and each partition comprises at least one functional device; and
the circuit board comprises a plurality of driving groups, the driving group comprises one driver chip and at least two partitions, and the driver chip is configured to independently drive each partition in the driving group, wherein
the driving groups comprise a first driving group, and the driver chip and the partitions in the first driving group are located on a same sub-board.

2. The circuit board according to claim 1, wherein
the partitions in the first driving group are arranged in a rows*b columns, a column direction is parallel to the first direction, a row direction is parallel to the second direction, both a and b are positive integers, a≥1, b≥1, and a and b are not 1 at the same time.

3. The circuit board according to claim 2, wherein
in the first driving group, the driver chip is located inside an area occupied by the a rows*b columns.

4. The circuit board according to claim 1, wherein
the driver chip comprises an input terminal and an output terminal, and the functional device is coupled to the output terminal; and
the common connection part comprises a plurality of external connection terminals, and the input terminal of each driver chip is coupled to the external connection terminal.

5. The circuit board according to claim 1, wherein
the plurality of functional devices on each sub-board are arranged in a same manner.

6. The circuit board according to claim 1, wherein
in the circuit board, two functional devices that are adjacent in the second direction are at an equal spacing, wherein
the two functional devices that are adjacent in the second direction are located on a same sub-board, or the two functional devices that are adjacent in the second direction are respectively located on two adjacent sub-boards.

7. The circuit board according to claim 1, wherein
the circuit board has a virtual straight line that extends in the second direction, the virtual straight line intersects each sub-board, a part that is of the virtual straight line and that is located between adjacent sub-boards is a spacing line segment, and each spacing line segment has an equal length.

8. The circuit board according to claim 1, wherein
the driving groups comprise a second driving group, the driver chip in the second driving group is located in the common connection part, and the partitions in the second driving group belong to n sub-boards, wherein n≥2, and n is an integer.

9. The circuit board according to claim 1, wherein
a shape of the sub-board is any one of a long strip shape, a fold line shape, a sawtooth shape, and a shape of 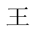 .

10. The circuit board according to claim 1, wherein
the connection part is an end part of the sub-board in the first direction, and each sub-board extends from a same side of the common connection part in a direction away from the common connection part.

11. The circuit board according to claim 1, wherein
the connection part is an end part of the sub-board in the first direction, the sub-board comprises a first sub-board and a second sub-board, and the first sub-board and the second sub-board respectively extend from two sides of the common connection part in a direction away from the common connection part; and
the first sub-board and the second sub-board are staggered in the first direction.

12. The circuit board according to claim 1, wherein
the connection part is an end part of the sub-board in the first direction, the sub-board comprises a first sub-board and a second sub-board, and the first sub-board and the second sub-board respectively extend from two sides of the common connection part in a direction away from the common connection part; and
the first sub-board is aligned with the second sub-board in the first direction.

13. The circuit board according to claim 1, wherein
b=1, or b=2.

14. The circuit board according to claim 1, wherein
the functional device comprises at least one of a light emitting device, a photosensitive device, and an ultrasonic device.

15. A backlight module, wherein the backlight module comprises the circuit board according to any one of claims 1 to 14.

16. A display module, wherein the display module comprises a display panel and the backlight module according to claim 15.

17. An electronic device, wherein the electronic device comprises the circuit board according to any one of claims 1 to 14.
